**Europäisches Patentamt**

**European Patent Office**

**Office européen des brevets**

(19)

(11) Publication number : **0 324 580 B1**

## EUROPEAN PATENT SPECIFICATION

(12)

(45) Date of publication of patent specification : **22.03.95 Bulletin 95/12**

(51) Int. Cl.⁶ : **G11C 11/411**

(21) Application number : **89300185.9**

(22) Date of filing : **10.01.89**

(54) **Bipolar memory cell.**

(30) Priority : **11.01.88 US 142032**

(43) Date of publication of application : **19.07.89 Bulletin 89/29**

(45) Publication of the grant of the patent : **22.03.95 Bulletin 95/12**

(84) Designated Contracting States : **DE FR GB IT NL**

(56) References cited :
**EP-A- 0 029 717**
**EP-A- 0 196 715**

(73) Proprietor : **SYNERGY SEMICONDUCTOR CORPORATION**
**3450 Central Expressway**
**Santa Clara California 95051 (US)**

(72) Inventor : **Wong, Thomas Sing Wai**
**927 Rock Canyon Circle**
**San Jose California 95127 (US)**

(74) Representative : **Cross, Rupert Edward Blount et al**
**BOULT, WADE & TENNANT**
**27 Furnival Street**
**London EC4A 1PQ (GB)**

EP 0 324 580 B1

## Description

This invention relates generally to bipolar memory cells, and more particularly to a bipolar memory cell having a switched load for an improved write speed characteristic.

Bipolar memory cells are circuits wherein information may be stored in a low current standby mode and may be written into or read from in a higher current mode.

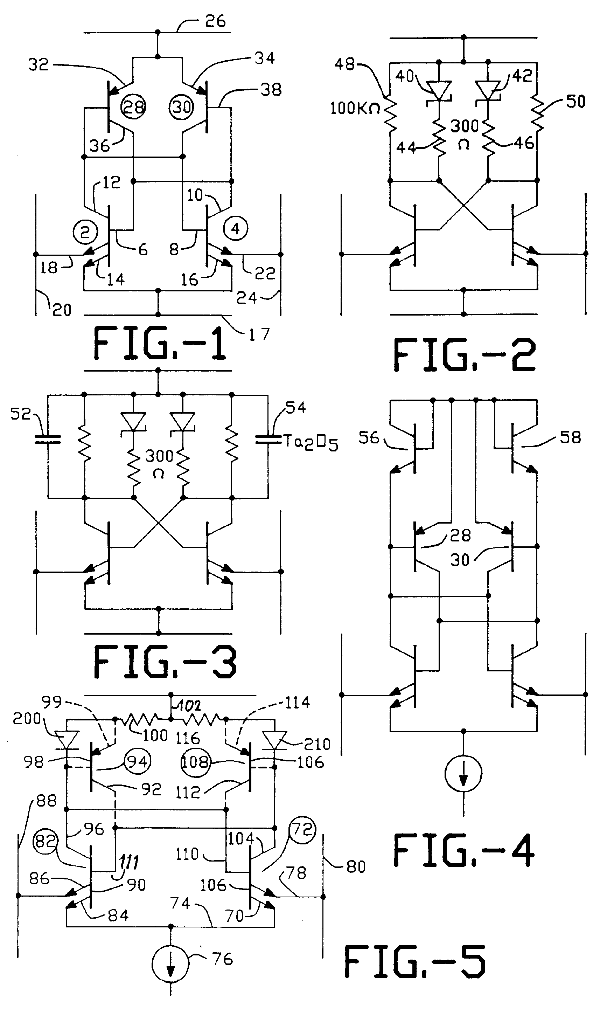

Many current bipolar memory cells comprise a pair of cross coupled multi-emitter transistors operating as a latch such as the transistors 2, 4 shown in FIG 1. The bases 6, 8 of the transistors are cross coupled to each others' collectors 10, 12. A first emitter 14, 16 of each transistor is coupled to a standby current drain line 17. A second emitter 18 of one transistor is connected to a first bit line 20 and a second emitter 22 of the second transistor 4 is connected to a second bit line 24. The collectors are further coupled to a row select line 26 through load PNP transistors 28 and 30.

The load implements the non-linear resistance required to maintain reasonable cell differential voltage under both low current standby mode and higher current read/write mode. In a previously developed load arrangement discussed in the article, "Technology Improvement for High speed ECL Rams", IEDM 86, 468-471, by Ogiue, Odaka, Iwabuchi and Uchida, a well known arrangement is described wherein a PNP transistor is utilized as the load. This arrangement, which also appears in FIG 1, uses first and second PNP transistors 28, 30 having their emitters 32, 34 connected to the select line 26. A collector 36 of the first PNP transistor is connected to the base 6 of the first multi-emitter transistor 2, the base 38 of the second PNP transistor 30, and the collector 10 of the second multi-emitter transistor 4. The second PNP transistor 30 is similarly connected. In this arrangement, either half of the cell operates as an SCR latch or what is commonly called a thyristor latch. It is characterized by the storage of a large amount of charge in the form of diffusion capacitance in the PNP and NPN transistors when the collector base regions of the PNP and NPN transistors are in saturation. This cell device, as with other prior art devices, described briefly below, is characterized by a fundamental charge storage problem in the base region of PNP and collector region of the multi-emitter NPN transistor. The stored charge occurs in the epi region of the cell. The charge storage results in a long write pulse width and long write recovery time for the cell. In order to write opposite data into the cell, the holes that have been injected into the epitaxial (epi) region or collector of the multi-emitter transistor, must be removed from the side of the cell that is being turned off and supplied to the side of the cell that is turning on or being written into.

An alternative approach to this charge storage problem is shown in FIG 2 wherein the load is provided by Schottky diodes 40, 42, each of the Schottky diodes being connected in series with a 300-500 ohm resistor 44, 46 and in parallel with a 20K-100K ohm resistor 48, 50. In the standby mode, the cell holds latch using the 100K ohm resistor; sensing occurs through the 300 ohm resistor. When a half cell is to be sensed, the 100K ohm resistor is transparent.

This cell provides fast write times, but is alpha particle sensitive.

Alpha particle immunity is an absolute requirement in high speed RAMs. Alpha particles may come from almost any material that is used in the fabrication of high speed RAMs. It was once thought that alpha particles came just from the ceramic package used to mount a high speed RAM. Therefore, the solution attempted was a thick coating of polyimide over the die. Later studies proved that alpha particles may occur in the aluminum or other materials used in RAM fabrication. Because the alpha particles occur in the material of which the product is made, the solution must be provided in the design of the part itself. Historically, any part designed to be alpha insensitive is also relatively harder to write. In order to maximize the speed of a RAM, it is necessary to overcome this deficiency. An effort to overcome the alpha particle problem is disclosed at FIG 3 which is also taken from the Ogiue article. In this design, a large tantalum oxide $Ta_2 O_5$ capacitor 52, 54 is placed in parallel with each of the Schottky diodes. However, this design has the deficiency of requiring a very high standby current and the integration of the capacitors 52, 54.

A more recent effort to overcome this deficiency is shown in US-A-4580244 which discloses the circuit shown in FIG 4. In this design, the emitter base junction of the PNP load transistor 28, 30 is clamped with an NPN transistor 56, 58 operating in the inverse mode. That is, each of the transistors 56, 58 has the base tied to the collector to act as a diode. This NPN transistor (56, 58) functions to steal current from the associated lateral PNP transistor 28, 30, in effect robbing base current and lowering the beta of this transistor. Therefore, less charge is stored and it is easier to write using this design. In other words, the configuration of FIG 4 is really a beta lowering mechanism which basically gives the PNP emitter lower emission efficiency. However the stored charge problem remains due to the fact that the SCR must hold latch for the cell to work.

EP-A-0029717 discloses a bipolar memory cell with the features of the preamble of claim 1 and comprising a pair of cross coupled multi-emitter transistors each connected to a load consisting of a resistor and diode connected in parallel. The N-type material of the diode is heavily doped so that holes injected into this region undergo quick recombination to reduce charge storage and therefore increase the switching speed. At the same time, the diode has a larger forward voltage across the junction and therefore has a larger noise margin. In one embodiment, the resistor is replaced by a PNP transistor and is equivalent to the memory cell shown in Figure 4, in which transistors 56 and 58 are equivalent to the PN diodes. The memory cell described in EP-A-0029717 also suffers from the stored charge problem since the circuit functions as an SCR when holding state.

Thus, a memory cell is needed that can differentiate so that it is alpha hard with trickle currents into it in the standby mode, but when it is being read using higher sense currents, it is easy to write. When a cell is being written or read, enough current can be used so that the alpha particles do not create a problem.

According to the present invention there is provided a bipolar memory cell comprising first and second multi-emitter NPN transistors, each having a read emitter coupled to respective first or second bit lines, each having a standby emitter coupled to a standby current line, each having a collector, and each having a base cross-coupled to said collector of said other multi-emitter transistor, a first PNP transistor having an emitter, and having a base and a collector respectively coupled to said collector and said base of said first multi-emitter transistor, a second PNP transistor having an emitter, and having a base and a collector respectively coupled to said collector and to said base of said second multi-emitter transistor, first and second resistors, each having first and second ends, each first end being coupled to a row select line and each second end being respectively coupled to the emitters of first and second PNP transistors, so that each said PNP transistor has a lower current gain for read mode current, and a higher current gain for standby mode current, during read mode said PNP transistors functioning as a PN diode formed by the emitter-base junction thereof, the bipolar memory cell operating as a switched load cell in that, when said standby emitters conduct standby current, said multi-emitter transistors are loaded by said first or second PNP transistors in series with said first or second resistors, wherein $\beta_{NPN} \cdot \beta_{PNP} > 1$, which condition latches a chosen pair of said first multi-emitter transistor and said first PNP transistor or said second multi-emitter transistor and said second PNP transistor, enhancing resistance to alpha particles, and when said read emitters conduct read current, said multi-emitter transistors are loaded by said first or second PN diodes in series with said first or second resistors, wherein

$$\beta_{NPN} \cdot \beta_{PNP} < 1,$$

which condition prevents latching of said bipolar memory cell, said resistors having a resistance sufficiently large to maintain state in said unlatched bipolar memory cell while being sufficiently low in resistance to prevent saturation of any said transistors to shorten write time.

The invention provides a cell having a short write pulse width.

Further, the invention provides a cell wherein each multi-emitter transistor is loaded by the PNP transistor when it is in standby for low alpha sensitivity, and effectively functions in a different configuration when active, so that when the cell is being read it will write easily.

Specifically, the cell of this invention combines the attributes of the PNP and diode load cells, and achieves both fast write times and alpha immunity.

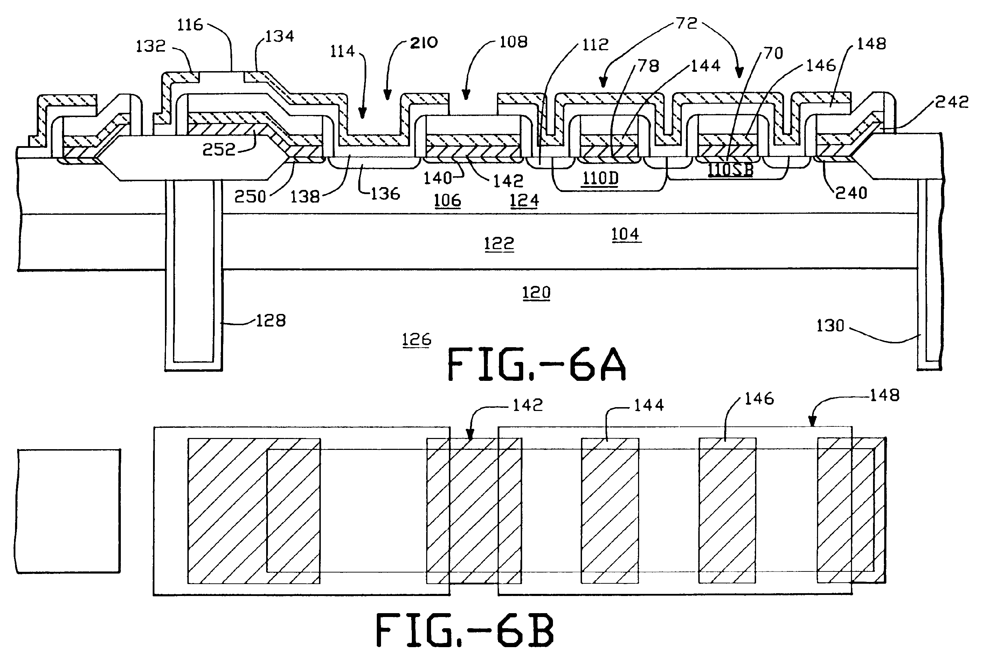

In summary, a switched load diode cell is provided wherein first and second multi-emitter NPN transistors are provided having bases cross coupled to the other's collectors in typical latch fashion as shown in Fig. 5. A PN diode is provided having an anode coupled to the select line through a load resistor and a cathode coupled to the collector of each associated multi-emitter transistor. A parasitic lateral PNP transistor associated with the PN diode is provided having an emitter coupled to the select line through the same load resistor and a collector connected to the base of the associated multi-emitter transistor. A relatively low resistance load of about 500Ω (500D) is connected between the common node which consists of the emitter of the parasitic lateral PNP transistor and the anode of the PN diode and the select line. In this way, a switched load diode cell is provided. The invention is based partly on the recognition that parasitic PNP beta rolls off heavily with current, and the parasitic PNP transistor is nothing more than a PN diode if the beta of the PNP ($beta_P$) is approximately 0 and little to no collector current is flowing. A design objective is to decrease the $beta_P$ to be very low at high current (sense current), and to have a beta product ($beta_P \times beta_N$) less than 1. In the standby mode, with only standby current flowing in the standby emitter of either multi-emitter transistor, $beta_P \times beta_{NSTBY}$ is much more than 1. Therefore, with low standby current, the cell acts just like a PNP loaded cell. But when the cell is being sensed, the cell effectively becomes a resistor with diode loaded cell.

Implementation is based on the knowledge that PNP beta rolls off heavily with current. In addition, when the cell is in standby, the current is drawn through the standby emitter, preferably at about 1 to 10 microamps. When the sense mode is desired, the sense current is received through the other emitter, preferably at .5 to 1 milliamp. Recognizing the function of the different emitter, a multi-emitter transistor is provided wherein the emitters can have different betas, the betas being achieved by providing a thicker base width and/or higher doping and thereby a lower beta for the reading emitter, and a thinner base width and/or lower doping, and therefore a higher beta for the standby emitter. The change can be achieved by implanting locally into the region defining the base for the outer or read emitter. Using this high/low beta approach, the implementation of the beta product requirement becomes much easier.

The virtue of this design is that, effectively, it differentiates the cell so that it is alpha hard when sleeping (holding data) while it has a trickle current into it, but when it is being read, it is easy to write. The design effectively forces the PNP and NPN transistors out of saturation when sensing, i.e. the epi region of the collector base junction of the PNP and NPN transistors will not store charge and will not saturate in the sensing mode. This function is a result of the fact that the beta of the PNP transistor rolls off heavily at high current, and that it is effectively co-operating with two NPN transistors having intrinsically different betas. If enough current flows in the bitline, the beta rolls off to a point where the product of the two betas ($beta_P$ x $beta_N$) is less that one, the PNP and NPN transistors are not in saturation, no stored charge is present, and writing is easily accomplished. The provision of the $500\Omega$ (500D) resistor in series with a PNP transistor which is not in saturation creates the functional appearance of a PN diode loaded cell for sensing and writing purposes.

Note that the roll-off in the beta, which is essential to the effective writing operation in combination with the PNP transistor, is achieved by providing the bit line emitter with a thicker base width and/or higher doping than the standby emitter base. The result of having the low beta bit line emitter coupled with a much higher sense/write current is that the product of the PNP beta and NPN beta is less than one during sensing and writing.

The invention will now be described by way of example with reference to the drawings, in which:-
Figs. 1, 2, 3 and 4 are schematic diagrams of prior art memory cells;
Fig. 5 is a schematic diagram of the preferred embodiment of the present invention;
Fig. 6A is a cross-section of a portion of a half cell;
Fig. 6B is a plan view of Fig. 6A; and
Figs. 7A, 7B and 7C illustrate constructions for the PN diode of Figs. 6A and 6B.

In Fig. 5, a memory cell in accordance with this invention is shown which is suitable for fabrication in monolithic integrated circuit form. Emitter 70 of the vertical NPN transistor 72 is connected to a standby current drain line 74. A current source 76 is provided connected to this standby current drain line 74 in a manner well known in the art. Read emitter 78 of the multi-emitter transistor 72 is connected to a bit line 80.

The other multi-emitter transistor 82 of the cell also includes first and second emitters 84, 86. The standby emitter 84 is also connected to the standby current drain line 74. The read emitter 86 is connected to a separate bit line 88. The cathode of PN diode 200 is connected to the collector of NPN transistor 82. The anode of the PN diode 200 is connected through a resistor 100 (preferably of a value of about $500\Omega$ (500D)) to a select line 102. The NPN transistor 82 has its base 90 connected to the collector 92 of PNP parasitic transistor 94. The collector 96 of the multi-emitter NPN transistor 82 is connected to the base 98 of PNP parasitic transistor 94, whose emitter 99 is connected to the anode of PN diode 200. The base 90 of the multi-emitter NPN transistor 82, in addition to being connected to the collector of parasitic PNP transistor 94, is also connected to the collector 104 of multi-emitter NPN transistor 72 in the cross coupled design which is well known in the technology. This collector 104 is also connected to the base 106 of a parasitic lateral PNP transistor 108 and cathode of PN diode 210. The base of the multi-emitter vertical NPN 72 is connected to the collector 112 of the parasitic PNP transistor 108. The emitter 114 of the parasitic PNP transistor 108 is connected to the anode of PN diode 210 through load resistor 116 (preferably of a value of about $500\Omega$ (500D) to select line 102.

As is well known in this technology, when a logical low signal appears on bit line 88 and a logical high signal appears on bit line 80, multi-emitter NPN transistor 82 is ON and NPN transistor 72 of the other half of the cell is OFF due to the respective voltages at their bases. When the low and high signals of bit lines 88 and 80 are removed, the latch state is maintained by the low current from current source 76 through the standby emitter 84 of the NPN transistor which is turned on. When the signals on bit lines 88 and 80 are reversed, that is to high and low respectively, transistor 82 is turned off and transistor 72 is turned on. When the high and low signals are removed, the latch state is now maintained by the low current of current source 76 through the emitter 70 of the switched on transistor 72.

The advantages of this invention are more clearly apparent in FIGs 6A and 6B, which illustrates how a half cell including the vertical NPN transistor 72, the PN diode 210 with its parasitic lateral PNP transistor 108, and resistor 116 are monolithically integrated to provide faster write pulse width. As shown in FIG 6A, the integrated structure is fabricated beginning with a P- silicon substrate 120. The N+ buried layer 122 which will function as a buried collector for the vertical devices is formed within the substrate 120, and the N- epitaxial layer 124 is grown over the N+ buried layer 122. The resistor 116, lateral PNP 108 and vertical NPN 72 are disposed adjacent one another as shown in the figure. This portion of the monolithically integrated circuit is electrically isolated from the remaining chip by oxide or trench isolations 128, 130. The various diffusions and implants used to form these devices should be apparent to a person of skill in the art from a study of FIGs 6A-6B.

Further details of the process may be found in a copending application, U.S. Serial No. 180,626 entitled "Process for Producing a High Performance Bipolar Structure," filed April 11, 1988, in the name of L. Pollack and G. Brown, and assigned to the Assignee of this invention.

Specifically, the resistor 116 is defined by omission of a portion of silicide layer 132, 134 in the region 116. This resistor 116 is connected through the conductive silicide layer 134 to the anode of PN diode 210 and emitter 114 of the parasitic lateral PNP 108. P region 136 which defines this parasitic anode and emitter is formed by a boron diffusion out of P poly layer 138. The base region 106 of the parasitic lateral transistor 108 lies adjacent to the emitter region 136. N region 140, 240, 250 that provide the PNP base contact is formed by an arsenic diffusion out of N poly region 142, 242, 252. It can be seen that this base region 106 is common to the collector regions 104 and 124 of the dual emitter vertical NPN transistor 72, providing the necessary connection thereto, appearing in FIG 5. The collector region 112 and 110 D of the parasitic PNP transistor 108 is formed in the same manner as PNP emitter 136 and is connected to the base region 110 SB and 110 D of the standby 70 and data read 78 emitters of the multi-emitter transistor 72. These base regions (110 SB and 110 D) are both formed by localized implants of P type material, the ion implant dosage and energy being modified to provide the differing beta. It can be seen that the base depth of the data emitter 78 is significantly thicker or deeper than the base associated with the standby emitter 70 to provide the modified beta which is important to the functioning of this device. (Alternatively, this could be achieved by heavier base doping of the base under the data emitter region 78 than the base under the standby emitter 70.) The contacts to the emitter region 70 78 are provided through the N poly layers 144, 146 shown more clearly in FIG 6B. The necessary contact to the base region of the multi-emitter transistor 72 is provided by the P poly region 148.

As discussed above, the configuration shown in FIGs 5, 6A and 6B provides the combined attributes of the PNP and diode loaded cell. As is apparent from FIG 6A, the emitter 70, 78 of the multi-emitter transistor 72 have been given different betas by providing the inner emitter 78 a thicker base 110D than the outboard emitter 70 having the thinner base 110SB. The outboard emitter 70, with its thinner base 110SB, has a higher beta. Given that the two transistors have intrinsically different betas, and the knowledge that the beta of the parasitic PNP transistor 108 and further the NPN transistor with emitter 78 will roll off heavily at high current, then by providing enough current in the bit line (preferably a chosen value of 1 milliamp), the beta will roll off in the sense and write mode, and the product of the NPN beta and parasitic PNP beta will be designed to be less than one. Therefore, the parasitic PNP transistor 108 and NPN transistor 72 will come out of saturation and write easily. Due to the presence of the 500Ω (500D) resistor 116 in series with the emitter 114 of the parasitic lateral PNP transistor 108, with that transistor out of saturation, a PN diode load in series with the NPN transistor 72 is created, allowing easy writing in this cell.

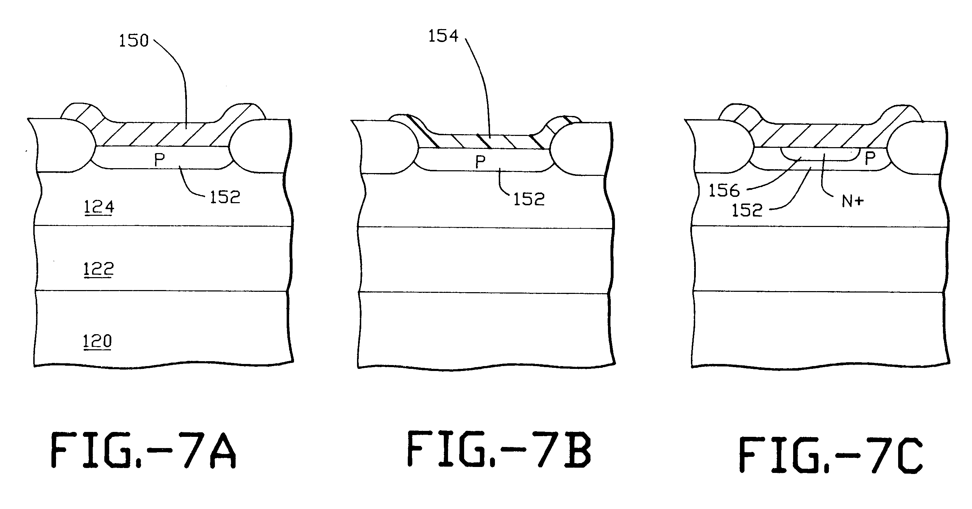

The PN diode schematically indicated at 200, 210 in FIG 5 can be incorporated in the structure of FIG 6A using any of the structures shown in FIG 7. For example, FIG 7A illustrates a PN diode formed by adding a metal contact 150 over a p-type region 152 formed in N epi layer 124. FIG 7B illustrates defining the diode using a P+ poly region 154 over p-type region 152. FIG 7C illustrates use of a metal contact 150 over p region 152 and region 156 defined to form an inverted transistor PN diode. Any of these structures would be consistent with the product and process disclosed in FIG 6A and 6B.

By this discussion, it should be appreciated that there has been provided a bipolar memory cell with an improved write characteristic for faster writing times, faster write recovery times and which is highly alpha particle insensitive.

## Claims

1. A bipolar memory cell comprising first and second multi-emitter NPN transistors (72,82) each having a read emitter (78,86) coupled to respective first or second bit lines, each having a standby emitter (70,84) coupled to a standby current line (74), each having a collector (104,96), and each having a base (110,111) cross-coupled to said collector (96,104) of said other multi-emitter transistor (82,72),

a first PNP transistor (108) having an emitter (114), and having a base (106) and a collector (112) respectively coupled to said collector (104) and said base (110) of said first multi-emitter transistor (72),

a second PNP transistor (94) having an emitter (99), and having a base (98) and a collector (92) respectively coupled to said collector (96) and to said base (111) of said second multi-emitter transistor (82);

characterised by first and second resistors (116,100), each having first and second ends, each first end being coupled to a row select line (102) and each second and being respectively coupled to the emitters of said first and second PNP transistors, so that

each said PNP transistor (108,94) has a lower current gain for read mode current, and a higher current gain for standby mode current, during read mode each said PNP transistors (108,94) functioning as a PN diode formed by the emitter-base junction thereof;

the bipolar memory cell operating as a switched load cell in that:

when said standby emitters (70,84) conduct standby current, said multi-emitter transistors (72,82) are loaded by said first or second PNP transistors (108,94) in series with said first or second resistors (116,100), wherein $\beta_{NPN} \cdot \beta_{PNP} > 1$, which condition latches a chosen pair of said first multi-emitter transistor (72) and said first PNP transistor (108) or said second multi-emitter transistor (82) and said second PNP transistor (94), enhancing resistance to alpha particles, and

when said read emitters (78,86) conduct read current, said multi-emitter transistors (72,82) are loaded by said first or second PN diodes in series with said first or second resistors (116,100), wherein $\beta_{NPN} \cdot \beta_{PNP} < 1$, which condition prevents latching of said bipolar memory cell, said first and second resistors (116,100) having a resistance sufficiently large to maintain state in said unlatched bipolar memory cell while being sufficiently low in resistance to prevent saturation of any said transistors (72,82,108,94) to shorten write time.

2. A bipolar cell according to claim 1, characterised in that each said first and second PNP transistor (108,94) is a lateral PNP transistor parasitic to said first or second PN diode.

3. A bipolar memory cell according to claim 1, characterised in that each of said first and second resistors (116,100) has a value of about 500 $\Omega$.

4. A bipolar memory cell according to claim 1, characterised in that said read current has a value of between 0.5 and 1 milliamp and said standby current has a value of between 1 to 10 microamps.

5. A bipolar memory cell according to claim 1, wherein said multi-emitter NPN transistors (72,82) exhibit a lower current gain associated with said read emitters (78,86) than is associated with said standby emitters (70,84).

6. A bipolar memory cell according to claim 1, wherein said multi-emitter NPN transistors (72,82) include a base width associated with said read emitters (78,86) that is wider than a base width associated with said standby emitters (70,84).

7. A bipolar memory cell according to claim 1, wherein said multi-emitter NPN transistors (72,82) include a base associated with said read emitters (78,86) that is more heavily doped than is a base associated with said standby emitters (70,84).

## Patentansprüche

1. Bipolare Speicherzelle mit einem ersten und einem zweiten npn-Mehrfachemitter-Transistor (72, 82) mit je einem an eine erste bzw. zweite Bit-Leitung angeschlossenen Lese-Emitter (78, 86) und je einem an eine Bereitschafts-Stromleitung (74) angeschlossenen Bereitschaftemitter (70, 84), je einem Kollektor (104, 96) und je einer mit dem Kollektor (96, 104) des anderen Mehrfachtransistors (82, 72) über Kreuz verbundenen Basis (110, 111),

einem ersten pnp-Transistor (108) mit einem Emitter (114), sowie einer Basis (106) und einem Kollektor (112), die mit dem Kollektor (104) bzw. der Basis (110) des ersten Mehrfachemitter-Transistors (72) verbunden sind,

einem zweiten pnp-Transistor (94) mit einem Emitter, sowie einer Basis (98) und einem Kollektor (92), die an den Kollektor (96) bzw. die Basis (111) des zweiten Mehrfachemitter-Transistors (82) angeschlossen sind,

gekennzeichnet durch einen ersten und einen zweiten Widerstand (116, 100) mit je einem ersten und einem zweiten Anschluß, wobei jeder erste Anschluß an eine Zeilen-Wählleitung (102) und jeder zweite Anschluß an die Emitter des ersten bzw. zweiten pnp-Transistors angeschlossen ist, so daß

jeder pnp-Transistor (108, 94) eine niedrigere Stromverstärkung für den Lese-Betriebsstrom und eine höhere Stromverstärkung für den Bereitschafts-Betriebsstrom aufweist und während des Lese-Betriebs jeder pnp-Transistor (108, 94) als durch seinen Emitter-Basis-Übergang gebildete pn-Diode wirkt,

wobei die bipolare Speicherzelle als geschaltete Lastzelle arbeitet, indem:

wenn die Bereitschaftsemitter (70, 84) Bereitschaftsstrom führen, die Mehrfachemittertransistoren (72, 82) durch den ersten oder zweiten pnp-Transistor (108, 94) in Reihe mit dem ersten bzw. zweiten Widerstand (116, 100) belastet werden, wobei $\beta_{npn} \times \beta_{pnp} > 1$, wobei diese Bedingung ein gewähltes Paar aus dem ersten Mehrfachemitter (72) und dem ersten pnp-Transistor (108) oder dem zweiten Mehrfachemitter-Transistor (82) und dem zweiten pnp-Transistor (94) verriegelt, und

wenn die Lese-Emitter (78, 86) Lesestrom führen, die Mehrfachemitter-Transistoren (72, 82) durch die erste oder zweite pn-Diode in Reihe mit dem ersten bzw. zweiten Widerstand (116, 100) belastet werden, wobei $\beta_{npn} \times \beta_{pnp} < 1$, wobei diese Bedingung eine Verriegelung der bipolaren Speicherzelle verhindert, und wobei der erste und zweite Widerstand (116, 100) einen Widerstand aufweisen, der ausreichend hoch ist, den Zustand in der unverriegelten bipolaren Speicherzelle aufrechtzuerhalten, während der Widerstand ausreichend gering ist, um eine Sättigung jedes der Transistoren (72, 82, 104, 94) zu verhindern und die Schreibzeit zu verkürzen.

2. Bipolare Zelle nach Anspruch 1, dadurch gekennzeichnet, daß der erste und der zweite pnp-Transistor (108, 94) ein zur ersten oder zweiten pn-Diode parasitärer pnp-Seitentransistor ist.

3. Bipolare Zelle nach Anspruch 1, dadurch gekennzeichnet, daß der erste und der zweite Widerstand (116, 100) einen Widerstandswert von etwa 500 Ohm haben.

4. Bipolare Speicherzelle nach Anspruch 1, dadurch gekennzeichnet, daß der Lesestrom einen Wert zwischen 0,5 und 1 mA und der Bereitschaftsstrom einen Wert von 1 bis 10 μA hat.

5. Bipolare Speicherzelle nach Anspruch 1, wobei die npn-Mehrfachemitter-Transistoren (72, 82) mit den Lese-Emittern (78, 86) eine geringere Stromverstärkung als mit den Bereitschaftsemittern (70, 84) haben.

6. Bipolare Speicherzelle nach Anspruch 1, wobei die npn-Mehrfachemitter-Transistoren (72, 82) eine den Lese-Emittern (78, 86) zugeordnete Basisbreite haben, die größer ist als die den Bereitschaftsemittern (70, 84) zugeordnete Basisbreite.

7. Bipolare Speicherzelle nach Anspruch 1, wobei die npn-Mehrfachemitter-Transistoren (72, 82) eine den Lese-Emittern (78, 86) zugeordnete Basis aufweisen, die stärker dotiert ist als die den Bereitschaftsemittern (70, 84) zugeordnete Basis.

## Revendications

1. Une cellule de mémoire bipolaire comprenant des premier et second transistors NPN multi-émetteurs (72, 82) ayant chacun un émetteur de lecture (78, 86) connecté à un premier ou un second conducteur de bit respectif, ayant chacun un émetteur d'attente (70, 84) connecté à un conducteur de courant d'attente (74), ayant chacun un collecteur (104, 96) et ayant chacun une base (110, 111) connectée en couplage croisé au collecteur (96, 104) de l'autre transistor multi-émetteur (82, 72),

un premier transistor PNP (108) ayant un émetteur (114) et ayant une base (106) et un collecteur (112) respectivement couplés au collecteur (104) et à la base (110) du premier transistor multi-émetteur (72),

un second transistor PNP (94) ayant un émetteur (99) et ayant une base (98) et un collecteur (92) respectivement couplés au collecteur (96) et à la base (111) du second transistor multi-émetteur (82);

caractérisée par des première et seconde résistances (116, 100), ayant chacune des première et seconde extrémités, chaque première extrémité étant couplée à un conducteur de sélection de ligne (102), et chaque seconde extrémité étant respectivement couplée aux émetteurs des premier et second transistors PNP, de façon que

chaque transistor PNP (108, 94) ait un gain en courant inférieur pour un courant de mode de lecture, et un gain en courant supérieur pour un courant de mode d'attente, chaque transistor PNP (108, 94) fonctionnant pendant le mode de lecture à la manière d'une diode PN formée par sa jonction émetteur-base;

la cellule de mémoire bipolaire fonctionnant à la manière d'une cellule à charge commutée, en ce que :

lorsque les émetteurs d'attente (70, 84) conduisent un courant d'attente, les transistors multi-émetteurs (72, 82) sont chargés par les premier ou second transistors PNP (108, 94) en série avec les première ou seconde résistances (116, 100), avec $\beta_{NPN} \cdot \beta_{PNP} > 1$, cette condition verrouillant une paire choisie formée par le premier transistor multi-émetteur (72) et le premier transistor PNP (108) ou par le second transistor multi-émetteur (82) et le second transistor PNP (94), ce qui renforce la résistance aux particules alpha, et

lorsque les émetteurs de lecture (78, 86) conduisent un courant de lecture, les transistors multi-émetteurs (72, 82) sont chargés par les première ou seconde diodes PN en série avec les première ou seconde résistances (116, 100), avec $\beta_{NPN} \cdot \beta_{PNP} < 1$, cette condition empêchant le verrouillage de la cellule de mémoire bipolaire, les première et seconde résistances (116, 100) ayant une valeur de résistance suffisamment élevée pour maintenir l'état dans la cellule de mémoire bipolaire non verrouillée, tout en ayant une valeur de résistance suffisamment faible pour empêcher la saturation de n'importe quel transistor (72, 82, 108, 94), de façon à raccourcir le temps d'écriture.

2. Une cellule bipolaire selon la revendication 1, caractérisée en ce que chaque premier et second transistors PNP (108, 94) est un transistor PNP latéral parasite vis-à-vis de la première ou de la seconde diode PN.

3. Une cellule de mémoire bipolaire selon la revendication 1, caractérisée en ce que chacune des première et seconde résistances (116, 100) a une valeur d'environ 500 $\Omega$ .

4. Une cellule de mémoire bipolaire selon la revendication 1, caractérisée en ce que le courant de lecture a une valeur comprise entre 0,5 et 1 milliampère, et le courant d'attente a une valeur comprise entre 1 et 10 microampères.

5. Une cellule de mémoire bipolaire selon la revendication 1, dans laquelle les transistors NPN multi-émetteurs (72, 82) présentent un gain en courant associé aux émetteurs de lecture (78, 86) qui est inférieur à celui associé aux émetteurs d'attente (70, 84).

6. Une cellule de mémoire bipolaire selon la revendication 1, dans laquelle les transistors NPN multi-émetteurs (72, 82) ont une largeur de base associée aux émetteurs de lecture (78, 86) qui est supérieure à une largeur de base associée aux émetteurs d'attente (70, 84).

7. Une cellule de mémoire bipolaire selon la revendication 1, dans laquelle les transistors NPN multi-émetteurs (72, 82) comprennent une base associée aux émetteurs de lecture (78, 86) qui est plus fortement dopée qu'une base qui est associée aux émetteurs d'attente (70, 84).

FIG.-1

FIG.-2

FIG.-3

FIG.-4

FIG.-5

FIG.-6A

FIG.-6B

150

P

124

122

120

152

**FIG.-7A**

154

P

152

**FIG.-7B**

P

156

152

N+

**FIG.-7C**